(19) Europäisches Patentamt
European Patent Office
Office européen des brevets

(11) Publication number: **0 304 174 A2**

# (12) EUROPEAN PATENT APPLICATION

(21) Application number: 88306821.5

(22) Date of filing: 25.07.88

(51) Int. Cl.4: G03F 7/10 , G03C 1/68

(30) Priority: 19.08.87 GB 8719589

(43) Date of publication of application: 22.02.89 Bulletin 89/08

(84) Designated Contracting States: AT BE CH DE ES FR GB GR IT LI LU NL SE

(71) Applicant: IMPERIAL CHEMICAL INDUSTRIES PLC
Imperial Chemical House Millbank
London SW1P 3JF(GB)

(72) Inventor: Chisholm, Michael Stephen
31 Sidelings Tails
Yarm Cleveland TF15 9HT(GB)

(74) Representative: Thomas, Ieuan et al
Imperial Chemical Industries PLC Legal Department: Patents PO Box 6 Bessemer Road
Welwyn Garden City Herts, AL7 1HD(GB)

## (54) Bismaleimide compositions.

(57) A photo-curable composition which comprises a component having more than one addition-polymerisable maleimide group, a further addition polymerisable composition and a photo-initiator composition and which (i) on curing gives a green-stage product which can be shaped and then post-cured, to afford a thermally stable high Tg product or (ii) can be used as a high temperature adhesives.

EP 0 304 174 A2

Xerox Copy Centre

## BISMALEIMIDE COMPOSITIONS

The present invention relates to bismaleimides and processes for the curing thereof, particularly to bismaleimide compositions which are curable by exposure to electromagnetic radiation.

It is known that bis-maleimides can be cured to produce polymers which have high Tg's, often above 250 °C, and good thermal stability, often up to at least 350 °C. The aforesaid curing process is typically effected thermally, in the presence or absence of catalyst, at temperatures above the softening point of the bis-maleimide and often above 140 °C.

Typically, commercially-available bis-maleimides are solid at room temperature. For example, bis-maleimides of the General Formula I,

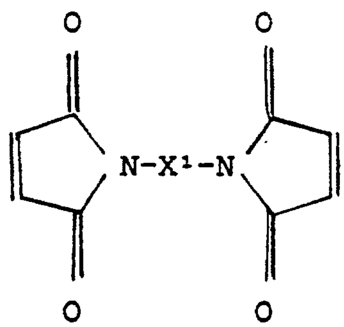

I

wherein $X^1$ is an aromatic residue, e.g.

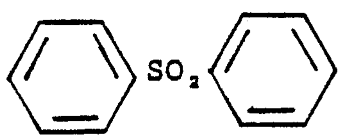

or an aliphatic residue, e.g. $-(CH_2)_{12}-$, tend to have melting points higher than 150 °C; e.g. 250 °C and 160 °C respectively for each of the compounds bearing the above two X residues. Thus, it will be appreciated that where such bis-maleimides are to be processed, for example in filling a mould or in impregnating a fibre, e.g. carbon fibres, the application of heat to melt the bis-maleimide is often necessary. Known bis-maleimides are more fully described in "Structural Adhesives: Developments in Resins and Primers", Kinloch (ed), Elsevier 1986, Stenzenberger p 80 et seq.

The curing of bis-maleimides typically involves a polymerisation or cross-linking step, e.g. in a mould, press or autoclave, at elevated temperature, e.g. 140-190 °C, such that a solid so-called "green-stage product" is formed. The green-stage product may then be transferred to an oven, where cure may be completed, i.e. so-called "post-curing", is carried out and a product, often having a high Tg, is produced.

The cross-linking of di-functional compounds or polymers, both of which contain both a terminal disulstituted maleimide residue and distant therefrom, a terminal and/or pendant addition - polymerisable group, e.g. a methacrylate, are known, e g from US 4500629, US 4193927, US 4626497, UK 1544 299 and Japanese 59-2444. In these specifications it is disclosed that such compositions may be used as printed plates.

By photo-curable, as used herein, we mean a composition which on suitable exposure to electromagnetic radiation homo- or co-polymerises such that it changes from a fluid phase to a solid phase (i.e. the cured product).

By post-curing, as used herein, we mean subjecting a polymerised composition to more forcing polymerising conditions, e.g. heat or heat/light, such that polymerisation of a material present therein, which contains more that one polymerisable double bond, takes place and cross-linking occurs.

We have now prepared compositions comprising a bis-maleimide, which compositions are fluid, e.g. liquid or resinous, at room temperature and, suprisingly, are light-curable at room temperature. We have found suprisingly that such compositions can be cured, e.g. to the green-stage product, on exposure to certain electromagnetic radiation, e.g. of 380-520 nanometres, for about at least 10 seconds. The green-stage product may then be post-cured in the conventional way, i.e. by heating to a high temperature, e.g.

about 200° C. Moreover, suprisingly the post-cured product tends to have a Tg and thermal stability characteristics at least about the same as those of the cured product from the neat bis-maleimide from which it is derived, for example

| Thermal Properties of Post-Cured Product | | |
|---|---|---|
| | From neat bis-maleimides | From composition according to the present invention (as is more fully described hereinafter at Example 4) |
| Tg (° C) | 380 | 350 |
| Decomposition Temp (° C) | 410 | 390 |

Such a post-curing process can often be carried out at a lower temperature, for a shorter time than post-curing processes used hitherto for post-curing bis-maleimides.

According to a first aspect of the present invention there is provided a photo-curable composition which comprises:

Component A: a bis-maleimide, as hereinafter defined;

Component B: an addition polymerisable composition; and

Component C: a suitable photo-initiator composition.

By "bis-maleimide" we mean a compound which contains more than one addition-polymerisable maleimide group.

According to a further aspect of the present invention there is provided a process for the preparation of a post-cured composition which process comprises at least the steps of

(A) irradiating a photo-curable composition according to the first aspect of the present invention with suitable elctromagnetic radiation such that polymerisation of component B is initiated and a solid product is formed; and

(B) subjecting the product from Step A to a heat treatment such that cross-linking thereof is effected, and the post-cured composition is obtained.

Bis-maleimides of which component A is comprised may be linear or branched. They preferably contain at least two, particularly preferably between 2 and 5, and more particularly preferably about two maleimide groups.

As examples of bis-maleimides of which photo-curable composition according to the present invention are comprised may be mentioned <u>inter alia</u> bis-maleimides of the General Formula II

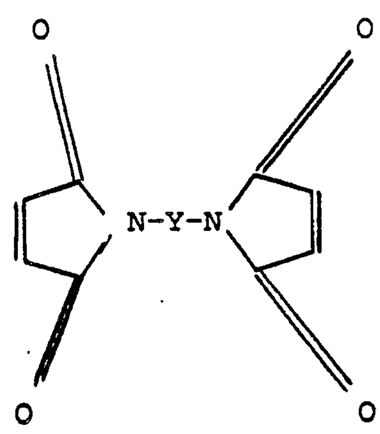

II

wherein

Y is a divalent group, for example

(a) an alkylene group, e.g. $-(CH_2)_n-$, where n is 1-12, or $-CH_2C(CH_3)_2CH_2CH(CH_3)CH_2CH_2-$,or

(b) preferably an aromatic residue $Ar^1$, e.g.

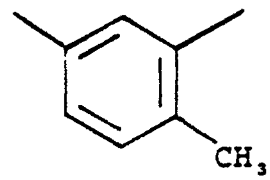

or more preferably

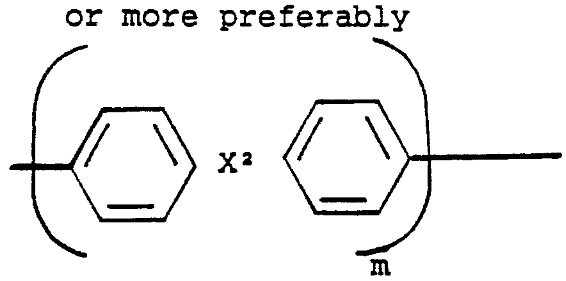

where $X^2$, which may be the same or different, is -O-, $-SO_2$, $-CH_2-$, -CO- or $-C(CH_3)_2-$; and m is an integer up to 6.

Alternatively, chain extended maleimide components, e.g. with hydrazides or diamines, of the general formula III may be used

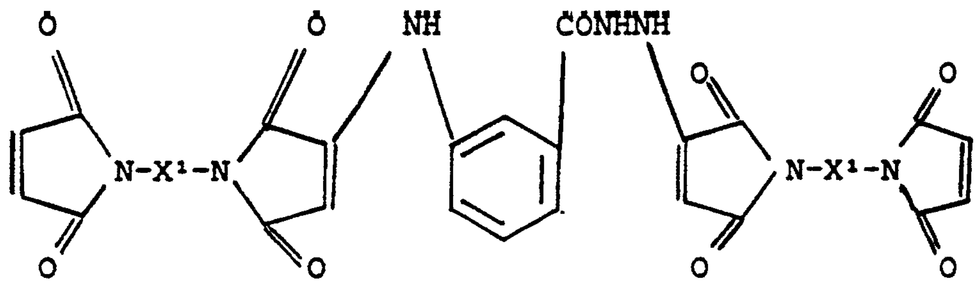 III

wherein $X^1$ has the meaning hereinbefore ascribed to it.

It is often preferred that the bis-maleimide is a mixture of bis-maleimides of General Formula II wherein Y is

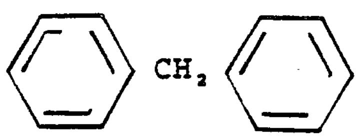 , 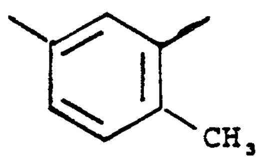 and

$-CH_2C(CH_3)_2CH(CH_3)CH_2CH_2-$, (including isomeric mixtures thereof).

Whereas we do not exclude the possibility that one or more of the maleimide groups in General Formula II and III may bear one or more subtituents on the olefinically unsaturated bonds therein, this is not preferred.

Component B is chosen such that inter alia it has low viscosity and affords an acceptable shrinkage on curing. Whereas we do not exclude the possibility that Component B may be a neat addition-polymerisable oligomer, it is often preferred that Component B comprises both an addition-polymerisable oligomer and a liquid addition-polymerisable monomer of low viscosity. As examples of the aforesaid addition-polymerisable oligomer may be mentioned inter alia (meth)acrylate-ended urethanes, eg as described in our UK Patent Specifications Nos 1,352,063, 1,465,897 and 1,498,421 or preferably oligomers containing in-chain aromatic rings, e.g. as disclosed in our European Patent Specification No 0,112,650A, the disclosure in which is incorporated herein by way of reference.

As examples of liquid comonomers which may be present in photo-curable compositions according to the present invention and which contain one polymerisable olefinically unsaturated group may be mentioned readily available monomers selected from the classes including inter alia hydrocarbons, e.g. styrene; ethers,

e.g. vinyl ethyl ether; esters, e.g. vinyl acetate, methyl methacrylate, ethyl acrylate, butyl methacrylate and 2-ethylhexyl methacrylate; and amides, e.g. N-vinyl pyrrolidone, and N-alkyl acrylamides.

Preferably, however, comonomers, where present in photo-curable compositions according to the present invention, (i) are low viscosity compounds which facilitate preparation of the composition by melt-blending and (ii) contain a plurality of polymerisable olefinically unsaturated groups. As examples of such compounds may be mentioned (alk)acrylic acid esters of polyhydroxy compounds, for example, diethylene glycol, trimethylolpropane and pentaerythritol, e.g. trimethylolpropane trimethacrylate, or preferably triethylene glycol dimethacrylate.

The photo-initiator composition for use in the present invention generates free-radicals on exposure to a source of electromagnetic radiation which acts as an initiator for the polymerisation of Component B and optionally the co-polymerisation of Components A and B. It may consist of a single conpound or it may comprise at least two components. Typically, it comprises any of the known photo-initiator systems which are used to initiate addition polymerisation of polymerisable olefinically unsaturated monomers. As examples of such compositions may be mentioned inter alia (a) mixtures of Michler's ketone and benzil or preferably benzophenone, typically in a weight ratio of about 1:4; (b) the coumarin-based photoinitiator systems described in US 4,289,844, (c) combinations of hexaarylbisimidazoles and leuco dyes, (d) cyclohexadiene-leuco dye systems described in US 4,241,869, or (e) systems based on dimethoxyphenyl-acetophenone (benzil dimethyl ketal) and/or diethoxyacetophenone or (f) preferably mixtures of amines and ketones as disclosed in our UK Patent Specifications Nos 1,408,265 and 1,494,903, e.g. camphorquinone, fluorenone or morpholine and N,N-dimethylaminoethyl methacrylate, typically in a weight ratio of about 1:1; or (g) more preferably mixtures of a light-sensitive initiator system and a peroxide, e.g. an α-diketone, a reducing agent capable of reducing the ketone when the latter is in an excited state, e.g. an organic amine, and a peroxide, as disclosed in our European Patent Specifications Nos 0,059,649, and 0,090,493, the disclosures in which are incorporated herein by way of reference. The presence of such a peroxide often facilitates the "post-curing" step, i.e. Step B in the process according to the further aspect of the present invention.

Ketones suitable for use in Component C in the compositions of the present invention tend to show some photosensitive catalytic action on their own in the absence of an organic peroxide. Such activity of the ketone is enhanced by the addition of an organic amine as described in our aforesaid British patent specification 1408265. Preferably, the present ketones are selected from fluorenone, benzil or more preferably is camphorquinone and substituted derivatives thereof, which ketone in admixture with a similar amount of organic amine which is capable of reducing that ketone when the latter is in an excited state, but in the absence of organic peroxide catalyst, cure an ethylenically unsaturated material. Preferably, the ketone which is used has a low volatility at ambient temperature. By the term "substituted derivatives" is meant that one or more of the hydrogen atoms in the respective unsubstituted ketones is/are substituted by hydrocarbyl or substituted hydrocarbyl groups, provided that the substituents do not substantially inhibit the cure of the resulting composition. Examples are lower alkyl (C1-6), halo-, or nitro-. Such substituted ketones include, for example p,p′-dialkoxy benzil, e.g. p,p′-dimethoxybenzil; p,p′-dihalobenzil, e.g. p,p′-dichlorobenzil; p,p′-dialkyl benzil, e.g. p-tolil; p,p′-dinitrobenzil; fluorenone-2-carboxylic acid; and fluorenone-4-carboxylic acid.

The ketone may, for example, be present in the photo-curable composition in a concentration in the range 0.01% to 2% by weight of the polymerisable material in the composition although concentrations outside this range may be used if desired. Preferably the α-diketone is present in a concentration of 0.1% to 1% by weight of the ethylenically unsaturated materials in the composition.

The ketones should be soluble in the polymerisable material, i.e. components A and B, and the above concentrations refer to solution concentrations.

The rate at which the photo-curable composition of the present invention cures under the influence of visible light can be increased by incorporation into the composition a reducing agent whch is capable of reducing the ketone when the latter is in an excited state. Such reducing agents are described in German Offenlegungsschrift 2251048 and are preferably organic amines having the formula $R^1N$ where the groups $R^1$, which may be the same or different, are hydrogen atoms, hydrocarbyl groups, substituted hydrocarbyl groups or groups in which two units $R^1$ together with the nitrogen atom form a cyclic ring system; no more than two of the units $R^1$ being hydrogen atoms and where N is attached directly to an aromatic group $R^1$, at least one of the other units $R^1$ has a $-\underset{\mathrm{H}}{\underset{|}{\mathrm{C}}}-$ group attached to the nitrogen atom.

The reducing agent is preferably present in the composition in concentration in the range 0.01% to 2% by weight of the polymerisable material although concentrations outside this range may be used if desired.

The organic peroxides, where present in the photo-curable composition according to the present invention include those having the formula

$R^2$-O-O-$R^2$

in which the groups $R^2$ which may be the same or different, are hydrogen, alkyl, aryl, or acyl groups, no more than one of the groups $R^2$ being hydrogen. The term acyl means groups having the formula

$R^3$ -CO-

in which $R^3$ is an alkyl, aryl, alkoxy or aryloxy group. The terms alkyl and aryl include substituted alkyl and aryl.

It will be appreciated that the organic peroxide, where present in the photo-curable composition according to the present invention, and the amount thereof, will be chosen such that it does not inadvertently catalyse cross - linking of the composition to an underisable extent prior to step B of the process according to the present invention and does catalyse cross-linking in Step B in a useful length of time. Choice of a suitable peroxide will be readily determined by the skilled man.

Examples of organic peroxides suitable for use in the composition of the present invention include diacetyl peroxide, dibenzoyl peroxide, ditertiary butyl peroxide, dilauroyl peroxide, tertiary-butyl perbenzoate, ditertiary-butyl-cyclohexyl perdicarbonate.

The organic peroxide may be, for example, present in the composition in the range 0.1% to 20%, preferably 0.5% to 5%, by weight of the polymerisable material in the composition although concentrations outside this range may be used if desired.

The reactivity of a peroxide is often measured in terms of its half-life temperature, i.e. within ten hours at that temperature half of the oxygen has been made available.

The peroxides in the present compositions preferably have ten-hour half-life temperatures of less than 150 °C, more preferably less than 110 °C.

A preferred photo-initiator composition comprises camphorquinone, N,N′-dimethylaminoethyl methacrylate and tert-butyl perbenzoate, preferably in the weight ratio about 1:1:1.

Mixing of the Components may be effected by stirring together the bismaleimide (Component A), the addition-polymerisable composition (Component B) and optionally any filler. It may be useful to dissolve the catalyst components (Component C) first in the polymerisable material, ie the mixture of Components A and B; the polymerisable material may conveniently be diluted with a suitable diluent so as to improve dissolution of the catalyst components therein. When mixing has been effected the diluent may be removed if desired, e.g. by evaporation.

The weight ratio of Component A to Component B in photo-curable compositions according to the present invention is between 10:90 and 90:10; preferably between 35:65 and 70:30; and more preferably between 40:60 and 60:40.

The weight ratio of oligomer to monomer in Component B, where a monomer is present therein, is between about 90:10 and 20:80 preferably between 80:20 and 40:60 and more preferably between 70:30 and 50:50.

The concentration of the photoinitiator composition in photocurable compositions according to the present invention is typically about 1-3% w/w.

It will be appreciated that that part of the preparation of photo-curable compositions in which the photo-initiator composition is added, and subsequent manipulations, e.g. preparation of a film or paste, should be carried out in the substantial absence of the electromagnetic radiation to which the photo-initiator composition is sensitive.

Where a filler and a copolymerisable comonomer are present the concentration of comonomer may be chosen to give a refractive index equal to the refractive index of the filler, thus rendering the composition substantially transparent to the curing radiation and hence increasing the depth of cure.

Preferably the photo-curable composition according to the present invention is microscopically homogeneous, this tends to improve the rate of curing and the mechanical properties of the cured product

Where one or more additives, e.g. fillers, heat and light stabilisers, anti-oxidants, colouring materials, reinforcing materials or inert diluents, are present in the photo-curable composition according to the present invention it will be appreciated that it (they) are such that it (they) do not unduly diminish the transparency or translucency of the compositions. Where the transparency or translucency of the photo-curable composition is unduly diminished the curing thereof may be reduced or prevented.

It is believed, without detriment to the present invention, that on exposure of the photo-curable composition to actinic radiation, Component B polymerises, i.e. the oligomer substantially homo-polymerises, or copolymerises with the monomer, where a monomer is present, such that the green-stage product is prepared. Although, we do not exclude the possibility that,a proportion of the bis-maleimide may copolymerise with Component B at this stage.

Photocurable compositions according to the present invention are typically prepared by melt-blending Components A and B, particularly where Component B comprises both an oligomer and a low viscosity monomer, and then adding the photoinitiator composition. Alternative methods of preparation of the photo-curable composition will be readily apparent to the skilled man.

Whereas we do not exclude the possibility that the composition according to the present invention may be used as the matrix for carbon fibre composites, such use is not preferred; it is often difficult to obtain acceptable depths of cure. Typically, compositions according to the present invention are used as high temperature adhesives, for example in opto-electronic, e.g. bonding lithium niobate, electronic and small structural applications For example, they may be used inter alia for

(1) bonding ceramics together, particularly where such ceramics are based on alumina which is less than 3mm thick;

(2) bonding sensors to metals, eg in the cooler parts of aircraft engines;

(3) bonding fibre-optics to ceramics; and

(4) encapsulating fibre-optic joints.

In the aforesaid applications, the fast cure-speed of the photo-curable composition is often advantageous compared with the extended time taken for epoxy resins to cure in such applications.

Still further aspects of the present invention provide post-cured resins derived from a photo-curable composition as defined in the first aspect of the present invention and composites in which such cured resins provides the matrix.

The invention is now illustrated by the following Examples.

In the Examples: number average and weight average molecular weights were determined by gel permeation chromatography on a Waters Liquid Chromatograph fitted with µ Styragel (Registered Trade Mark) columns; and flexural properties were determined under the conditions of ASTM D790-71.

Examples 1-6

These Examples illustrate photocurable composition according to the present invention having a range of component ratios.

In these Examples, the bis-maleimide had the General Formula I and was a mixture of bis-maleimides wherein X had separately the meanings

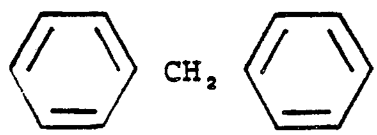 , 56% w/w

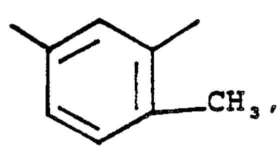 24% w.w

and an isomeric mixture of

$-CH_2C(CH_3)_2CH_2CH_2(CH_3)CH_2CH_2-$- 18% w/w

which mixture of bis-maleimides is hereinafter referred to for convenience as "MC1" (such mixutures of bis-maleimides may be obtained from Technochemie as "Compimide 353"); Component B was a mixture of a methacrylate-ended oligomer prepared as in Example 14 of our EP 0,112,650A (hereinafter referred to for convenience as "WB31") and triethylene glycol dimethacrylate; Component C was a mixture of camphorquinone (0.8% w/w), N,N′-dimethylaminoethyl methacrylate (0.8% w/w) and tert-butyl peroxybenzoate (1.0% w/w) (which % w/w are based on the weight of the polymeriable composition, i.e. components A, B and C).

Components A and B were mixed by melt-blending at about 70°-90°C in an oven or on a hot-plate. The mixture was cooled and Component C was then stirred into the cooled transparent mixture.

The composition was degassed at 60-70°C under vacuum and then poured into moulds (typically comprising two glass plates with rubber or PTFE spacer (for Dynamic Mechanical Analysis (DMA): 60 x 60 x 2 mm; for determining flexural properties: 30 x 2 x 2 mm)).

DMA samples were cured by exposure for 5-10 minutes to blue light filtered at 380-520 nanometers

with a power output of 35 $mW/cm^2$. Flex test samples were cured by exposure for about 10 seconds to blue light filtered at 450-490 nanometers from a 15v 150w tungsten halogen lamp with power output of 0.1 $w/cm^2$. Transparent mouldings were obtained. The mouldings were demoulded and post-cured at 150 °C for 1 hour, 190 °C for 5 hours, and 240 °C for 1 hour, sequentially. In a comparative test, i.e. without bis-maleimide, the 240 °C treatment was not carried out since thermal decomposition set in at this temperature, e.g. blackening of the sample and evolution of smoke was observed.

Flexural modulus and strength of the post-cured samples were determined on samples (30 x 2 x 2 mm) by a 3 point bend procedure under the conditions defined in ASTM D790-71.

The composition used and the properties of the products are given in Table 1.

TABLE 1

| Example No | Composition % w/w | | | Column X | Column Y | Brookfield viscosity (poise) | | | Column Z | Depth of Cure (mm) | Flexural | |
|---|---|---|---|---|---|---|---|---|---|---|---|---|
| | Component A | Component B | | DMA[1] Tg (°C) | DMA Temp where Flex Mod = 1.0 GPa | 25°C | 30°C | 40°C | TGA[2] % w/w weight loss at 370°C | | Modulas (GPa) | Strength (MPa) |
| | MC 1 | WB31 | TEG | | | | | | | | | |
| 1 | 10 | 70 | 20 | 154 | 199 | 96 | 53 | 18 | 5.0 | 8 | 2.9 | 106 |
| 2 | 20 | 60 | 20 | 152 | 216 | 182 | 132 | 30 | 4.7 | 5 | 2.8 | 109 |
| 3 | 30 | 50 | 20 | 157 | 200 | 305 | 147 | 49 | 3.9 | 4 | 3.0 | 105 |
| 4 | 40 | 40 | 20 | 349 | 293 | 438 | 206 | 56 | 2.8 | 3 | 3.7 | 118 |
| 5 | 50 | 25 | 25 | 341 | 290 | 312 | 142 | 37 | 2.8 | 3 | 3.7 | 96 |
| 6 | 60 | 20 | 20 | 336 | 283 | a | a | a | 2.2 | 2-3 | 3.6 | 69 |
| CT | 0 | 80 | 20 | 134 | 183 | 52 | 30 | 12 | 5.0 | 10 | 3.8 | 84 |

TEG: Triethylene glycol dimethylacrylate

CT: comparative test

a: Not determined

DMA[1]: Tg is defined as the intersection of tangents to the modulus-temperature curve

TGA[2]: Under $N_2$ at 10°C/min.

From Table 1 it can be seen that: (a) from Column X, the products have higher Tg's than the product from the Comparative Test; (b) from Column Z, the products are more thermally stable at 370°C than the product from the Comparative Test; and (c) from Column Y, that the rigidity of the products is decreased less than the rigidity of the product from the Comparative Test.

Examples 7-9

These Examples illustrate the use of a non-preferred Component B of photo-curable compositions according to the present invention.

The procedure of Examples 1-6 was repeated except that as Component B glycidyl methacrylate of General Formula IV (hereinafter referred to for convenience as "D1")

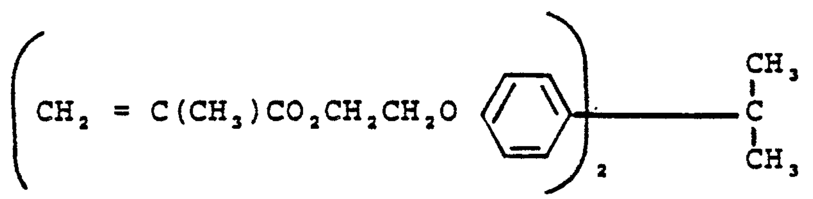

IV

was used instead of the mixture of WB31 and triethylene glycol dimethacrylate. The results are shown in Table 2.

TABLE 2

| Example No | Composition (% w/w) | | DMA Tg (°C) |
|---|---|---|---|
| | Component A MC1 | Component B D1 | |
| 7 | 30 | 70 | a |
| 8 | 50 | 50 | a |
| 9 | 70 | 30 | 75 |
| a: not determined | | | |

During the post-cure step, it was found that heating at 240°C caused the samples to decompose thermally. Furthermore, DMA revealed that the products (post-cured up to 190°C) had modulus/temperature behaviour which was inferior to those of Examples 1-6.

Examples 10-12

These examples illustrate the use of a further non-preferred Component B.

The procedure of Examples 1-6 was repeated except that a mixture of D1 and diallyl phthalate was used instead of the mixture of WB31 and triethylene glycol dimethacrylate. The results are shown in Table 3.

TABLE 3

| Example No | Composition (% w/w) | | | DMA Tg (°C) |
|---|---|---|---|---|
| | Component A | Component B | | |
| | MC1 | Oligomer D1 | Monomer DAP | |
| 10 | 50 | 10 | 40 | a |
| 11 | 50 | 25 | 25 | a |
| 12 | 50 | 40 | 10 | 50 |
| a: Not determined | | | | |
| DAP: Diallyl phthalate | | | | |

It was found that the light-curing step required a 2-4 fold increase in exposure time compared with Examples 1-6. Furthermore, at post-curing at temperatures above 190 °C thermal decomposition was observed, e.g. the samples blackened and evolution of smoke occurred; the post-cured (at up to 190 °C) products had modulus temperature behaviour which was inferior to those of Examples 1-6.

Examples 13-14

These Examples illustrate the use of a further bismaleimide.

The procedure of Examples 1-6 was repeated except that a bis-maleimide (hereinafter referred to for convenience as "PWJ 126") prepared as in Example 20 of our copending European Patent Specification No 0,274,203 was used instead of "MC1".

Preparation of PWJ 126

A mixture of p-phenoxyphenylmaleimide (132.9 gm) trioxan (70 gm), diphenyloxide (42.5 gmn), triflic acid (2 ml) and dried dichlorethane (800 ml) was heated to 70 °C (Mixture A). A mixture (Mixture B) of diphenyl oxide (42.5 gm) and dried dichlorethane (200 ml) was added over 3 hours to Mixture A. Further portions of triflic acid (each of 2 ml in dichloroethane (100 ml)) were added to the reaction mixture 1 hour and 2 hours after the aforesaid addition was complete. Three hours after the aforesaid addition was complete, the reaction temperature was raised to 80-85 °C to remove water by slow evaporation.

After a total reaction time of five hours , the reaction mixture was cooled. It was washed with sodium bicarbonate solution, dried, filtered and added dropwise to hexane. A pale yellow powder was precipitated (190 gm) which had a softening point of about 70 °C (Kofler Block), an $M_n$ of 1200 and $M_w$ of 4400. It was soluble in acetone, methyl ethyl ketone, dichloromethane, chloroform, tetrahydofuran, dioxan and N,n-dimethyl-formamide; and cured very quickly above 200 °C.

The compositions used in Examples 13 and 14 and the properties of the products produced therefrom are shown in Table 4.

TABLE 4

| Example No | Composition % w/w | | | Flexural Strength (MPa) | Flexural Modulus (GPa) | DMA Tg (°C) | DMA temp where Flex Mod = 1.0 GPa (°C) | Brookfield Viscosity (poise) | | |
|---|---|---|---|---|---|---|---|---|---|---|
| | Component A | Component B | | | | | | 25°C | 30°C | 40°C |
| | PWJ 126 | WB31 | TEG | | | | | | | |
| 13 | 20 | 30 | 50 | 129 | 2.8 | 140 | 177 | 6.7 | 4.7 | 2.2 |
| 14 | 40 | 30 | 30 | 104 | 2.6 | 160 | 198 | a | 382 | 210 |

a : Not determined

TEG: Triethylene glycol dimethacrylate

From Table 4 it can be seen that the compositions of Examples 13-14 have higher Tg's than the product from the WB31/triethylene glycol dimethacrylate comparative test (CT in Table 1; 134° C)

Example 15

This Example illustrates retention of certain flexural properties at high temperature of a post-cured product of the present invention.

A photo-curable compositon as described in Example 4 was light-cured under the general conditions described in Examples 1-6.

The product was then post-cured at 150° C for 1 hour and 280° C for 1 hour.

The DMA of the post-cured product was found to be 355° C. The flexural modulus and strength of the post-cured product was determined as a function of temperature under the conditions defined in ASTM D790-71. The results of the determination are shown in Table 5.

TABLE 5

| Temp (° C) | Flexural Modulus (GPa) | Flexural Strength (MPa) |
|---|---|---|
| 25 | 4.68 | 125 |
| 100 | 2.35 | 65 |
| 150 | 2.24 | 63 |
| 200 | 1.94 | 38 |

From Table 5 it can be seen that the product has an acceptable flexural modulus at 200° C.

Example 16

This Example illustrates the retention with ageing of certain properties of a post-cured product of the present invention.

The procedure of Example 4 was repeated except that it was stopped after the light -curing stage. The products were post-cured at 150° C for 1 hour, then 220° C for 2 hours and then aged in an oven at 200° C for 100 hours or 500 hours. The flexural properties of the cooled aged products, determined under the conditions described in Example 15, are shown in Table 6.

TABLE 6

| Ageing time at 200° C (hours) | Flexural Modulus (Gpa) | Flexural Strength (MPa) |
|---|---|---|
| 0 | 4.85 | 122 |
| 100 | 4.49 | 110 |
| 500 | 4.10 | 101 |

From Table 6, it can be seen that the thermal retention of flexural properties is good.

Example 17-19

These examples illustrates the use of a photo-curable compositions according to the present invention as an adhesive.

Components A and B were mixed by melt blending at 70° C-90° C. The mixture was cooled and

Component C was stirred into the transparent mixture.

A sample of the mixture was extruded from a blackened syringe onto a plate of thickness 1mm (measuring about 5mm x 2mm), a second plate of the same substrate having the same dimensions was placed over the sample and the plates were squeezed together.

The sample was exposed through one of the plates to blue light at 450-490 nanometres for 30 seconds. The plates were found to have adhered to each other.

Details of the photo-curable composition and the substrates used in these examples are given in Table 7 and 8 respectively.

TABLE 7

| Component A (%) | Component B (%) | | Component C (%) |
|---|---|---|---|
| MC1 40 | WB31 30 | TEG 30 | As used in Examples 1-6 |

TABLE 8

| Example No | Substrate |
|---|---|
| 17 | Glass |
| 18 | Alumimium |
| 19 | Fibre-glass reinforced epoxy-resin so-called FR4 |

Example 20-22

These examples illustrates the use of a composition according to the present invention as an adhesive.

Samples of a composition as prepared in Example 4 were separately placed between 2 alumimium plates, 2 stainless steel plates and 2 mild steel plates. The systems were cured by heating and certain mechanical properties of the products were measured. The results are shown in Table 9.

TABLE 9

| Example No | Substrate | Temp (°C) | Failure Stress (kN) | Lap Shear Strength MPa |
|---|---|---|---|---|
| 20 | Alumimium | 200 | 0.59 | 1.89 |
| 21 | Stainless Steel | 200 | 1.29 | 3.90 |
| 22 | Mild Steel | 100 | 0.89 | 2.80 |

**Claims**

1. A photo-curable composition which comprises
Component A: a compound containing more than one addition-polymerisable maleimide group;
Component B: an addition polymerisable composition;
Component C: a suitable photo-initiator composition.

2. A photo-curable composition as claimed in Claim 1 wherein Component A is a compound containing between 2 and 5 addition - polymerisable maleimide groups.

3. A photo-curable composition as claimed in claim 1 wherein Component B comprises both an addition-polymerisable oligomer and an addition-polymerisable monomer of low viscosity.

4. A photo-polymerisable composition, as claimed in Claim 3 wherein the addition-curable oligomer comprises in-chain aromatic rings.

5. A photo-curable composition as claimed in Claim 3 wherein the addition-polymerisable monomer comprises one or more (alk)acrylic acid esters of polyhydroxy compounds.

6. A photo-curable composition as claimed in Claim 1 wherein the photo-initiator composition comprises a ketone and a reducing agent which agent is capable of reducing the ketone when the latter is in an excited state.

7. A photo-curable composition as claimed in Claim 1 wherein the photo-initiator composition comprises a mixture of an amine and a ketone as disclosed in UK 1,408,265 or UK 1,494,903.

8. A photo-curable composition as claimed in Claim 6 or 7 wherein the ketone is camphorquinone.

9. A photo-curable composition as claimed in Claim 6 wherein the reducing agent is an organic amine having the formula $R^1{}_3N$ as hereinbefore defined.

10. A photo-curable composition as claimed in Claim 1 wherein the photo-initiator composition comprises a mixture of a light-sensitive initiator system and a peroxide.

11. A photo-curable composition as claimed in Claim 1 wherein the weight ratio of Components A:Component B is between 40:60 and 60:40.

12. A photo-curable composition as claimed in Claim 3 wherein, in Component B the ratio of addition-polymerisable oligomer to monomer is between 70:30 and 50:50.

13. Use of the photo-curable composition claimed in Claim 1 for:

(1) bonding ceramics together, particularly where such ceramics are based on alumina which is less than 3mm thick;

(2) bonding sensors to metals, eg in the cooler parts of aircraft engines;

(3) bonding fibre-optics to ceramics;

(4) encapsulating fibre-optic joints.

14. Resins, and composites derived therefrom, formed by curing a photo-curable composition as claimed in Claim 1.

15. A process for the preparation of a post-cured product which process comprises at least the steps of

(a) irradiating a photo-curable composition as claimed in Claim 1 with suitable electromagnetic radiation such that polymerisation of Component B is initiated and a solid product is formed; and

(b) subjecting the product from Step A to a heat treatment such that cross-linking thereof is effected and the post-cured product is obtained.

16. A composition which comprises Components A and B as defined in Claim 1.